(19) Europäisches Patentamt
European Patent Office
Office européen des brevets

(11) **EP 2 497 588 A1**

(12) **EUROPEAN PATENT APPLICATION**

(43) Date of publication:
**12.09.2012 Bulletin 2012/37**

(51) Int Cl.:
**B22F 9/24** (2006.01)   **B22F 1/00** (2006.01)
**H01L 31/0352** (2006.01)

(21) Application number: **11382064.1**

(22) Date of filing: **10.03.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Universidad de Barcelona**
**08028 Barcelona (ES)**

(72) Inventors:
• **Cabot Codina, Andreu**
  **08310, ARGENTONA (ES)**

• **Shavel, Alexey**
  **08024, BARCELONA (ES)**
• **Ibáñez Sabaté, María**
  **43560, LA SENIA (ES)**

(74) Representative: **ZBM Patents**
**Zea, Barlocci & Markvardsen**
**Plaza Catalunya, 1**
**08002 Barcelona (ES)**

(54) **CONTINUOUS FLOW PROCESS FOR THE PREPARATION OF COLLOIDAL SOLUTIONS OF NANOPARTICLES, COLLOIDAL SOLUTIONS AND USES THEREOF**

(57)   A continuous flow process for the preparation of a colloidal solution of $Cu_2A_xSnSe_y$ nanoparticles, wherein A is selected from Cd, Hg, Ni and Zn, $0 \leq x \leq 1$, and $3 \leq y \leq 4$, which comprises a) mixing in a continuous flow reaction unit under inert atmosphere and at an appropriate temperature, an appropriate amount of each of i) a solution of an A salt in an inert organic solvent; ii) a solution of a Sn salt in an inert organic solvent; iii) a solution of a Cu salt in an inert organic solvent; iv) a Se coordination compound; and, v) one or more stabilising agents selected from primary $(C_{12}\text{-}C_{18})$-amine, a $(C_{12}\text{-}C_{18})$-carboxylic acid, a $(C_{10}\text{-}C_{14})$-phosphonic acid, and a mixture of any of the amines with any of the acids; the inert organic solvent is equal or different for each salt, has a dielectric constant <10, and a boiling temperature between 100-350°C; b) progressively heating the mixture up to a temperature between 100-350°C at a speed between 10 s-1 0 min; and, c) collecting the resulting $Cu_2A_xSnSe_y$ nanoparticle colloidal solution of step b). A colloidal solution of $Cu_2A_xSnSe_y$ nanoparticles with an average size between 1-100 nm, and a variance of the size distribution up to 20%, wherein A is selected from Cd, Hg and Ni, $0 \leq x \leq 1$, and $3 \leq y \leq 4$; and uses thereof. And methods for the manufacture of a photovoltaic cell, a photodetector or a thermoelectric device, comprising preparing the colloidal solution as defined above, and applying the colloidal solution onto an appropriate substrate

EP 2 497 588 A1

**Description**

The present invention is related to the preparation of soluble and non-aggregated nanoparticles, i.e. colloidal solutions of nanoparticles with narrow size distribution and controlled size, shape and chemical composition. The present invention is also related to colloidal solutions of nanoparticles, and uses thereof.

BACKGROUND ART

Nanoparticles find applications in a wide range of disciplines, including biology, photovoltaic cells and optoelectronics. These applications are due to the special physical characteristics of nanoparticles such as their small size, their band gap tunability, their narrow electron energy bands transitions, long thermal relaxation times for excited charge carriers and plasmonic effects. These interesting properties are determined by the size, shape and chemical composition of the nanoparticles, which must be well-defined. Nanoparticles are prepared in the state of the art by many different methods exploiting chemical compounds as precursors. These methods include sol-gel methods, electrochemical methods, aerosol-based methods, and high vacuum methods, such as chemical vapour deposition, electron beam lithography, pulsed laser deposition and sputtering.

The limitation of the currently available methods is that the prepared nanoparticles are either aggregated or attached to a substrate and thus not available for ulterior solution-based processing and/or further applications. Furthermore, said methods are batch-type, which are more economic when the batch size is bigger; but, the bigger the batch size, the less control in the size, shape and chemical composition of the prepared nanoparticles, and the less uniform nanoparticle size distribution.

In spite of the numerous advances made in the field, there are still great limitations in the currently available preparation processes, limitations related to the preparation of nanoparticles of controlled size, chemical composition and shape, susceptible of being industrialised to allow the preparation process of large quantities of directly applicable nanoparticles, namely, of nanoparticle colloidal solution.

In view of the above, there is considerable interest in new processes for the preparation of well-defined nanoparticles to get over the failures and shortcoming of the preparation processes available in the current state of the art. Thus, the provision of a process for the preparation of nanoparticles in which the properties of the nanoparticles are fully controlled is highly desirable.

SUMMARY OF THE INVENTION

An aspect of the present invention relates to a new continuous flow process for the preparation of a colloidal solution of $Cu_2A_xSnSe_y$ nanoparticles, with an average size between 1 and 100 nm, and a variance of the size distribution up to 20%, wherein A is selected from Cd, Hg, Ni and Zn, $0 \leq x \leq 1$, and $3 \leq y \leq 4$, the process comprising: a) mixing in a continuous flow reaction unit under inert atmosphere and at an appropriate temperature, an appropriate amount of each of the following compounds to obtain an appropriate concentration of each of them in the mixture in order to yield nanoparticles of the desired average size, size distribution, shape and stoichiometry: i) a solution of an A salt in an inert organic solvent; ii) a solution of a Sn salt in an inert organic solvent; iii) a solution of a Cu salt in an inert organic solvent; iv) a Se coordination compound; and, v) one or more stabilising agents selected from the group consisting of a primary $(C_{12}-C_{18})$-amine, a $(C_{12}-C_{18})$-carboxylic acid, a $(C_{10}-C_{14})$-phosphonic acid, and a mixture of any of the $(C_{12}-C_{18})$-amines with any of the acids; wherein the inert organic solvent is the same or a different one for each salt, and wherein the inert organic solvent has a dielectric constant <10, and a boiling temperature comprised between 100 and 350°C; b) progressively heating the mixture of the compounds of step a) at an appropriate speed to increase the temperature of the mixture and set it to the reaction temperature between 100 and 350°C, wherein this step is carried out under an inert atmosphere, and the mixture of the compounds of step a) is kept at this reaction temperature for a period of time between 1 seconds and 60 minutes; and, c) collecting under an inert atmosphere the resulting $Cu_2A_xSnSe_y$ nanoparticle colloidal solution of step b).

The above preparation process has several advantages, namely, the precise control of the chemical composition (i.e. stoichiometry) of the $Cu_2A_xSnSe_y$ nanoparticles, and, consequently, the control of their band gap and optical absorption coefficient.

The above preparation process also allows the precise control of the nanoparticles' size, and the shape of their crystallographic domains, which influence the electric and thermal conductivity, and the charge carriers of the material.

The preparation process disclosed by the inventors has the additional advantage that allows the continuous preparation at industrial scale of colloidal solutions of $Cu_2A_xSnSe_y$ nanoparticles. This means the preparation of large amounts of semiconductor material with high output and a considerable reduction in the energy and labour costs.

Additionally, the reaction conditions needed for the preparation process of the present invention are ambient pressure and relatively low temperatures, in the range between 50 and 350°C.

As already mentioned, advantageously, the process of the present invention yields a nanoparticle colloidal solution, therefore, the nanoparticles are not agglomerated, so that they are easy to manipulate. The preparation process disclosed by the inventors has the additional advantage that the resulting nanoparticle colloidal solution can be either stored or directly used in further applications, e.g. the colloidal solution can be directly printed onto a substrate using conventional printing methods, such as ink-jet printing or roll to roll processing.

Another aspect of the present invention relates to a colloidal solution of $Cu_2A_xSnSe_y$ nanoparticles with a size between 1 and 100 nm, and a variance of the size distribution up to 20%, wherein A is selected from Cd, Hg and Ni, $0 \leq x \leq 1$, and $3 \leq y \leq 4$.

A still further aspect of the present inventions is related to the use of the colloidal solution of the present invention for the conversion of photons into an electric signal.

Furthermore, another aspect of the present invention is the use of the colloidal solution of the present invention for the conversion of photons into electric energy.

Another aspect of the present invention relates to a photovoltaic cell comprising the colloidal solution of the invention.

A still further aspect of the present invention is the use of the colloidal solution of the present invention for the conversion of thermal energy into electric energy.

Another aspect of the present invention relates to a thermoelectric device comprising the colloidal solution disclosed herein.

Furthermore, an aspect of the present invention is a LED comprising the colloidal solution of the present invention. And in still a further embodiment, it is provided a biological label comprising the colloidal solution of the present invention.

Still another aspect of the present invention relates to a method for the manufacture of a photovoltaic cell, comprising preparing the colloidal solution as defined in the present invention, and applying it onto an appropriate substrate.

Moreover, an aspect of the present invention is a method for the manufacture of a photodetector, comprising preparing the colloidal solution of the present invention, and applying the solution onto an appropriate substrate.

Finally, another aspect of the present invention relates to a method for the manufacture of a thermoelectric device, comprising preparing the colloidal solution of the present invention, and applying it onto an appropriate substrate.

BRIEF DESCRIPTION OF THE DRAWINGS

FIG. 1 Scheme of the continuous flow preparation process of the present invention, wherein the elements numbered as: "1" correspond to the receptacles; "2" are feeding pumps; "3" are heating systems; "4" is a cooling system; "5" is a temperature control unit; "6" is an additional control unit; "7" is a receptacle for collecting the nanoparticle colloidal solution; "8" is the reaction pipe; and "9" are additional pipes.

FIG. 2 Transmission electron microscopy (TEM) image of $Cu_2NiSnSe_4$ nanoparticles prepared following the preparation process of the underlying invention, as detailed for sample 8 of Table 1.

FIG. 3 TEM image of $Cu_2ZnSnSe_4$ nanoparticles prepared following the preparation process of the present invention, as detailed for sample 12 of

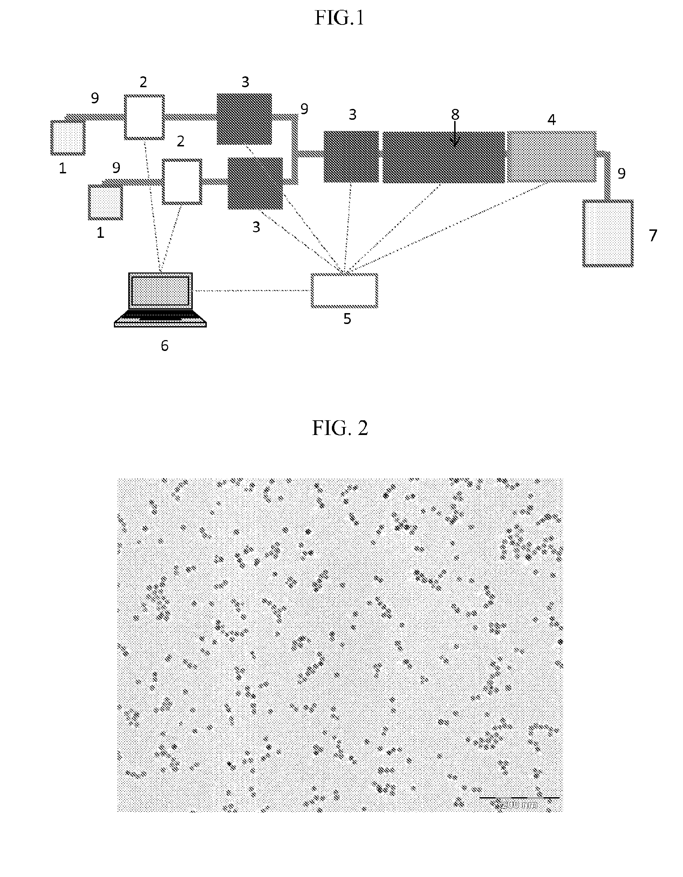

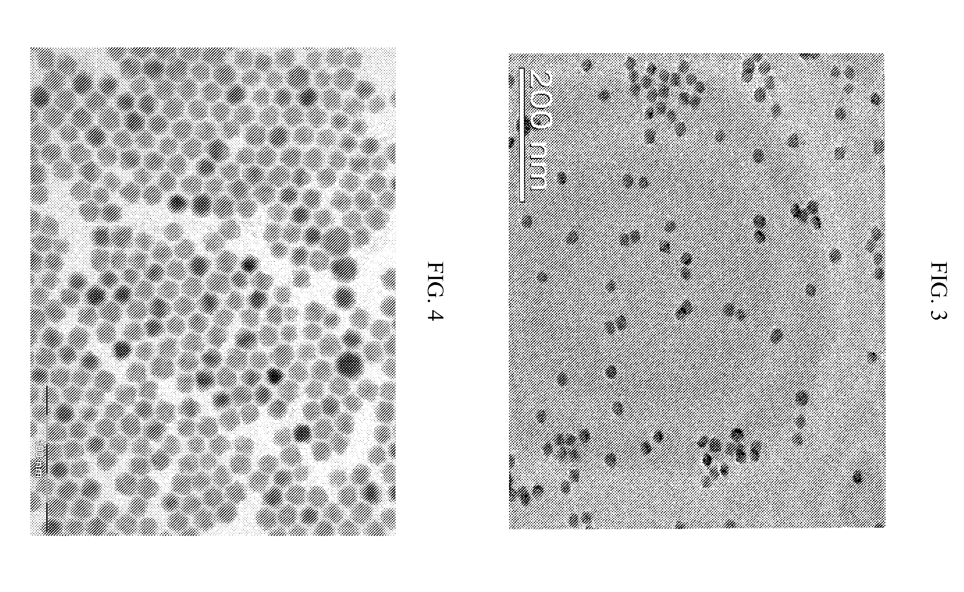

Table 1. TEM images corresponding to figures 2 and 3, show evidence for homogeneous composition within each nanocrystal. No contrast variation is observed inside each nanocrystal which means a homogeneous interaction with the electron beam inside the TEM, thus, a homogeneous density.

FIG. 4 TEM image of hexagonal 2D projection of $Cu_4HgSnSe_4$ nanoparticles prepared following the preparation process of the invention, as detailed for sample 15 of Table 1.

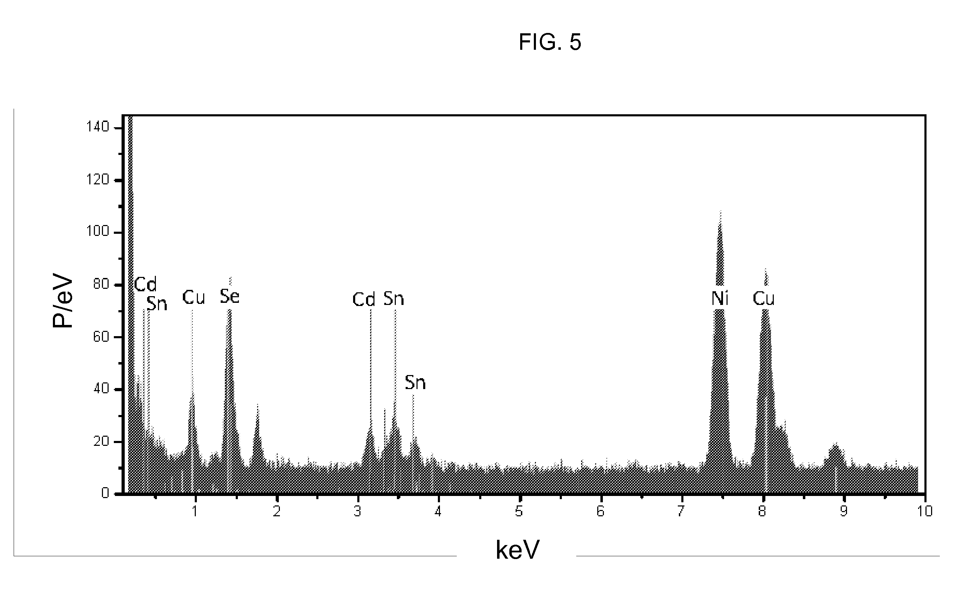

FIG. 5 Energy dispersive X-ray spectroscopy (EDX or EDS) showing the chemical composition of $Cu_4CdSnSe_4$ nanoparticles, prepared following the preparation process of the invention, as detailed for sample 16 of Table 1.

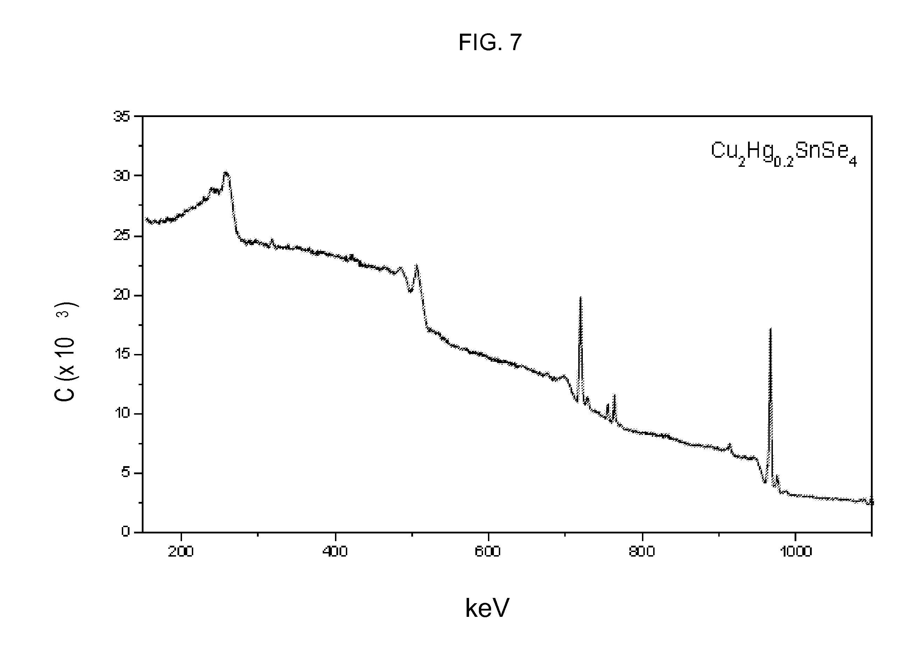

FIG. 7 Energy dispersive x-ray spectroscopy (EDX) showing the chemical composition of $Cu_4HgSnSe_4$ nanoparticles, prepared following the preparation process of the invention, as detailed for sample 15 of Table 1.

IG. 5 X-ray photoelectron spectroscopy (XPS) showing the chemical composition of $Cu_2Hg_{0.2}SnSe_4$ nanopar-

ticles, prepared following the preparation process of the present invention, as detailed for sample 2 of Table 1 ("C" stands for counts; and "BD" stands for binding energy).

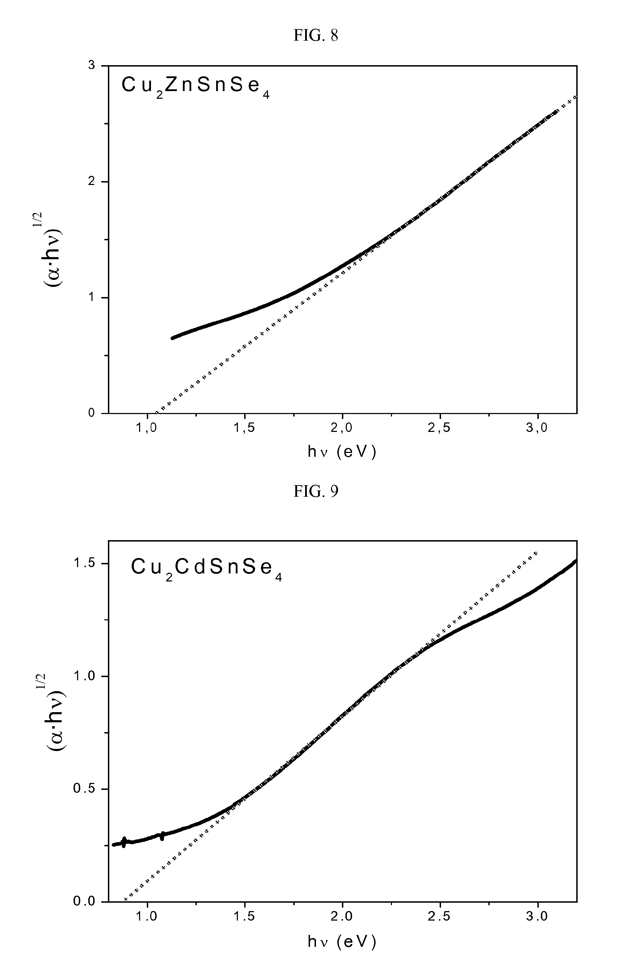

FIG. 8 Ultraviolet-visible absorption spectra of $Cu_2CdSnSe_4$ nanoparticles prepared following the preparation process of the present invention ("$\alpha$" is the optical absorption coefficient; "h" is Plank constant; and "$\gamma$" is the frequency).

DETAILED DESCRIPTION OF THE INVENTION

Definitions

In general, the following words or expressions have the indicated definition when used in the description and claims.

The terms "nanocrystal(s)" and "nanoparticle(s)" are used indistinctly in the present application.

The expressions "nanoparticle colloidal solution" and "colloidal solution of nanoparticles", used indistinctly herein, refer to a solution containing nanoparticles with narrow size distribution (or diameter), and with the appropriate surface properties that allow them to stay in solution without precipitation or aggregation.

The expression "size distribution" refers to the range of the sizes of the nanoparticles obtained in a given preparation process. It is mathematically identified by the variance of the distribution of the nanoparticles' sizes.

The term "precursor" is used to refer to the initial chemical compounds containing the chemical elements that after reaction will be present in the nanoparticles.

By the expression "activation of the precursor" is to be understood that the precursor is converted into an intermediate species, which may be metastable. If activated, the activated precursor(s) will take part on the final reaction to produce the nanoparticles.

The expression "reaction mixture" is the solution containing the (optionally activated) precursors, solvent(s) and stabilising agent(s).

The expression "reaction time" is to be understood as the time of residence of the reaction mixture in the reaction unit heated at the specific reaction temperature.

The expression "reaction unit" is the assembly of elements which provide the appropriate conditions for the reaction of the (optionally activated) precursors to take place.

The expression "reaction temperature" is to be understood as the set temperature at which the nanoparticles are grown.

The expression "heating ramp" refers to the increase of temperature per unit of time, set to reach the reaction temperature. It is calculated dividing the temperature difference between the initial (or preheating temperature) and the reaction temperature, by the time it takes the reaction mixture to reach the reaction temperature. The time to reach the reaction temperature depends on the flow rate, the distance between the initial receptacle(s) and the reaction unit, and the heat capacity of the solution.

The present invention overcomes all the aforementioned limitations.

As mentioned above, the preparation process of the present invention allows the preparation in a continuous flow of a colloidal solution of nanoparticles with a desired composition, average size, size distribution and shape. The composition, average size, size distribution and shape of the nanoparticles are controlled by specific parameters of the preparation process of the inventors.

The composition of the nanoparticles prepared is $Cu_2A_xSnSe_y$, wherein A is selected from Cd, Hg, Ni and Zn, $0 \leq x \leq 1$, and $3 \leq y \leq 4$.

A preferred embodiment, optionally in combination with one or more other embodiments described herein, relates to the continuous flow process of the present invention for the preparation of a colloidal solution of $Cu_2A_xSnSe_y$ nanoparticles, with an average size between 1 and 100 nm, and a variance of the size distribution up to 20%, wherein A is selected from Cd, Hg and Ni, $0 \leq x \leq 1$, and $3 \leq y \leq 4$. A further preferred embodiment, optionally in combination with one or more other embodiments described herein, relates to the continuous flow process of the present invention for the preparation of a colloidal solution of $Cu_2A_xSnSe_y$ nanoparticles, with an average size between 1 and 100 nm, and a variance of the size distribution up to 20%, wherein A is Zn, $0 \leq x \leq 1$, and $3 \leq y \leq 4$.

The general process of the underlying invention is exemplified in figure 1, which represents, without limitation, a scheme of the continuous preparation process of the present invention.

Basically, there is at least one feeding unit, comprising a receptacle, a feeding pump and a pipe. The appropriate amounts of the different compounds are stored at room pressure and temperature, and under an inert atmosphere, in the receptacle. Any suitable industrial or laboratory receptacle can be used as the receptacle in the process of the invention. Examples of receptacles, without limitation, are flasks or tanks provided with a septum.

Depending on the composition of the nanoparticles to be prepared, in particular, depending on whether the precursors needed to prepare the nanoparticles react with each other at room pressure and temperature to give an undesired product, one or more feeding units are necessary. The person skilled in the art is able to know the number of feeding units needed in the preparation process of the underlying invention for the preparation of each specific nanoparticle colloidal solution.

As guidance, and without limitation, in the case of the preparation of a colloidal solution of $Cu_2CdSnSe_4$ nanoparticles, following the process of the present invention, as detailed for samples 5-7 and 16 of Table 1 (cf. Example 2), due to the low reactivity at room pressure and temperature of the precursors used, only one feeding unit is needed. Whereas in the case of the preparation of a colloidal solution of $Cu_2CdSnSe_4$ nanoparticles following the process of the present invention, as detailed for samples 4 of Table 1 (cf. Example 2), two feeding units are needed.

As already mentioned above, the compounds used in the preparation process of the present invention are: i) a solution of an A salt in an inert organic solvent; ii) a solution of a Sn salt in an inert organic solvent; iii) a solution of a Cu salt in an inert organic solvent; iv) a Se coordination compound; and, v) one or more stabilising agent used to prevent the aggregation of the nanoparticles formed in the reaction unit.

Preferably, the Cd salt is $CdCl_2$. Preferably, the Hg salt is $HgCl_2$. Preferably, the Ni salt is $N_2NiO_6 \cdot 6H_2O$. Preferably, the Zn salt is ZnCl. Preferably, the Sn salt is $SnCl_4 \cdot 5H_2O$. And preferably, the Cu salt is selected from CuCl and $CuCl_2 \cdot 5H_2O$.

The inert organic solvent used to dissolve the above salts is the same or a different one for each salt. The inert organic solvent has a dielectric constant <10, and a boiling temperature higher than the reaction temperature so that the solvent(s) of the reaction mixture(s) delivered by the feeding unit(s) to the heated reaction unit do(es) not evaporate with the consequent precipitation of the dissolved mixture(s). The relatively broad region of applicable temperatures enables the synthesis of different types of nanoparticles. Preferably, the solvent used is selected from octadecene, squalane, dimethylsulfoxide, dimethylformamide, oleylamine, dichlorobenzene, and mixtures thereof.

The Se coordination compound is selected from Se-octadecene, Se-tryoctylphosphine, diphenyl diselenide, selenourea and Se-triethylphosphine. In a preferred embodiment, the Se coordination compound is selected from Se-octadecene, Se-tryoctylphosphine and diphenyl diselenide.

In a preferred embodiment, the stabilising agent is selected from a primary ($C_{12}$-$C_{18}$)-amine, a ($C_{12}$-$C_{18}$)-carboxylic acid, a ($C_{10}$-$C_{14}$)-phosphonic acid, and a mixture of any of the ($C_{12}$-$C_{18}$)-amines and any of the acids. In a more preferred embodiment, the primary ($C_{12}$-$C_{18}$)-amine used is selected from oleylamine, hexadecylamine and octadecylamine. In another preferred embodiment the ($C_{12}$-$C_{18}$)-carboxylic acid used is the oleic acid.

Depending on the stoichiometry (composition) of the nanoparticles prepared following the preparation process of the invention, the appropriate amounts of each of the compounds i) to v) to obtain the appropriate concentration of each of them in the reaction mixture are used. The person skilled in the art knows how to calculate the appropriate amounts of said compounds so that their concentrations in the reaction mixture are the appropriate ones to obtain the desired nanoparticle's stoichiometry (composition) (see examples 1 and 2). Each receptacle is connected through a pipe, so that the proper amount(s) of the mixture(s) of the above compounds is(are) injected into the pipe. The pipe can have an average size between 1 micrometer and 0.1 meter, at laboratory scale, and from several millimetres to 10 meters in an industrial reactor. In the case of industrial pipes, they should be properly isolated using any well known system available in the art. The pipe can be made of any suitable material that does not react with the solvent(s), precursors and stabilising agent(s). Examples of suitable pipe materials without limitation are heatresistant metal, glass and quartz.

The compounds mixture(s) flow(s) through the pipe(s) of the feeding unit(s) at a speed from 1 microliter per minute to 100 litres per minute.

Any feeding pump can be used in the preparation process of the present invention. Examples of feeding pumps, without limitation, are peristaltic pumps and (industrial) fluid injection pumps.

The process of the present invention has an optional preheating step, in which the precursor(s) in continuous flow of the above detailed mixture(s), is(are) activated in the pipe of the feeding unit(s) coming out of the corresponding receptacle(s) at the appropriate preheating temperature(s). Accordingly, the feeding unit may optionally have a heating system composed of a heating element and a temperature sensor. The preheating temperature(s) of the flowing mixture (s) in each of the feeding unit(s) is independently controlled by said heating system, especially, when the preparation process is at industrial scale. Examples of heating elements without limitation are heating mantles, heating cords, tubular ovens and heating baths.

The preheating temperature has a value between 50 and 100°C, and as already mentioned, it can be different for each feeding unit. The preheating temperature is more preferably between 90 and 100 °C. And most preferably, the preheating temperature is 100°C.

The, optionally preheated, compounds mixture(s) in continuous flow react in the reaction unit to obtain the colloidal nanoparticle solution. In the case where there is more than one receptacle, and, hence, more than one pipe, all the pipes unite in a single one, the so called reaction pipe in figure 1, in the reaction unit. The reaction unit comprises the reaction pipe, one or more heating systems as defined above, capable of allowing the, optionally preheated, reaction mixture flowing in the reaction unit to reach the reaction temperature,

Required reaction times are typically between 1 second and 60 minutes, and can be set by controlling the length of the reaction pipe, and the speed at which the reaction mixture flows in the reaction unit, this last parameter being controlled by means of the feeding unit(s).

It is well known by the skilled artisan, that the reaction time can be estimated based on the reaction pipe diameter, the length of the reaction pipe and the flow speed, using the following formula:

$$t = Pi \cdot l \cdot d^2/(4 \cdot f)$$

wherein "d" is the internal diameter of the pipe in meters (its section being given by $Pi \cdot (d/2)^2$); "f" is the flow speed in m/s; "l" is the length of the pipe in meters; and, "t" is the time of residence of the solution inside the pipe in seconds.

The reaction temperature has a value in the range of 100-350°C. Preferably the reaction temperature has a value in the range of 260-330°C.

The reaction unit is followed by a collecting unit, comprising a receptacle or collector (e.g. a vial, flask, bottle or tank) to store the resulting nanoparticle colloidal solution. Optionally, the colloidal solution of nanoparticles can be cooled before or after being collected. The cooling step is carried out by a cooling system. The cooling system is composed by a temperature controller and a cooling unit which removes heat from the solution. This cooling unit can be, without limitation, a thermoelectric element or any kind of oil or water circuit connected to a heat exchanger.

The feeding pump(s), the preheating temperature, the reaction temperature, the heating ramp and the reaction time of the above preparation process are continuously controlled and monitored through one or more control units.

Particular embodiments of the preparation process of the present invention are summarised in Table 1 below (cf. example 2).

The inventors have surprisingly found that the following reaction parameters:

(i) reaction temperature, (ii) reaction time (which also depends on the pipe's section length and the reaction mixture speed in the reaction unit), (iii) precursors' concentration and (iv) concentration(s) of the stabilising agent(s) in the reaction mixture, (v) heating ramp, and, in the case where the stabilising agent is a hydrocarbon with an amine, (vi) the hydrocarbon length, influence the composition, average size and shape of the nanoparticles.

Table 1 provides guidance, without limitation, on how the parameters can be modified to control the nanoparticle composition.

In particular, Table 1 summarises how to prepare $Cu_2Hg_{0.2}SnSe_4$, $Cu_2CdSnSe_4$, $Cu_2NiSnSe_4$, $Cu_2ZnSnSe_4$, $Cu_2SnSe_3$, $Cu_2Zn_{0.1}SnSe_{3.1}$, $Cu_2Cd_{0.5}SnSe_{3.5}$ and $Cu_2HgSnSe_4$ nanoparticles. As shown in Table 1 more than one set of parameters are possible.

Additionally, the average size of the prepared nanocrystals can be controlled by the reaction time, the reaction temperature, the precursors' concentration, the heating ramp and the concentration of the stabilising agent(s). Table 1, provides, guidance, without limitation, on how said parameters can be modified to control the nanoparticles average size.

Again as guidance, and without limitation, in general, longer reaction times, larger reaction temperatures, lower precursors' concentrations, higher heating ramps and smaller concentration of stabilising agent(s) result in larger nanoparticles.

Surprising and advantageously, the shape of the prepared nanoparticle can be controlled by the reaction temperature, the reaction time, the stabilising agent(s) selected, the precursor, the precursor's concentration and the nanocrystal composition.

As guidance, and without limitation, in general, the use of oleylamine as stabilising agent instead of hexadecylamine results in more asymmetric nanocrystals having hexagonal or rhombohedral 2D projection. Table 1 provides guidance, without limitation, on how the above mentioned parameters can be modified to control the nanoparticle shape, in particular spherical, discs, and polyhedral nanoparticles with different number of faces. As shown in Table 1, more than one set of parameters are possible (see also figure 4).

As already explained, the above parameters allow to control the composition, size and shape of the nanoparticles prepared following the preparation process of the inventors.

The continuous flow process of the present invention has the further advantage that the resulting nanoparticle colloidal solution can be used directly, e.g. to coat a substrate material (i.e. a photovoltaic cell), by means of the appropriate apparatus, in a roll-to-roll configuration.

The preparation process of the present invention may have the additional step of adding a binder to the nanoparticle colloidal solution. The binder can be any chemical compound or material having suitable adhesive properties that facilitate capturing and retaining the desired nanoparticles onto the appropriate substrate surface. Preferably, the binder is selected from semisynthetic resins (e.g. alkyd esters), chemically modified cellulose (such as nitrated cellulose, ethyl cellulose or sodium carboxymethyl cellulose), acrylic resins, polyvinyl acetate, polyvinyl alcohol, polyamide resins, polyurethane resins and epoxy resins.

In a preferred embodiment, optionally in combination with one or more other embodiments described herein, the binder is ethylcellulose. The binder is added when the colloidal solution is at a temperature that will not cause the decomposition of the binder. Accordingly, since the cooling step could be carried out before or after the collection step, if a binder is added to the nanoparticle colloidal solution, it may be added before or after the collection step. As already explained, the appropriate temperature at which the binder is added depends on the binder used. The skilled person is able to determine the decomposition temperature of the binder used. For instance, in the case of ethylcellulose, its decomposition temperature is between 135 and 155°C, so when using ethylcellulose as binder, the temperature of the nanoparticle colloidal solution before adding it should be below 135-155°C.

It is also part of the present invention a colloidal solution of $Cu_2A_xSnSe_y$ nanoparticles, with an average size between 1 and 100 nm, and a variance of the size distribution up to 20%, wherein A is selected from Cd, Hg and Ni, $0 \leq x \leq 1$, and $3 \leq y \leq 4$, obtainable by a continuous flow comprising: a) mixing in a continuous flow reaction unit under inert atmosphere and at an appropriate temperature, an appropriate amount of each of the following compounds to obtain an appropriate concentration of each of them in the mixture in order to yield nanoparticles of the desired size distribution, average size, shape and stoichiometry: i) a solution of an A salt in an inert organic solvent; ii) a solution of a Sn salt in an inert organic solvent; iii) a solution of a Cu salt in an inert organic solvent; iv) a Se coordination compound; and, v) one or more stabilising agents selected from the group consisting of a primary $(C_{12}-C_{18})$-amine, a $(C_{12}-C_{18})$-carboxylic acid, a $(C_{10}-C_{14})$-phosphonic acid, and a mixture of any of the $(C_{12}-C_{18})$-amines with any of the acids; wherein the inert organic solvent is the same or a different one for each salt, and wherein the inert organic solvent has a dielectric constant <10, and a boiling temperature comprised between 100 and 350°C; b) progressively heating the mixture of the compounds of step a) at an appropriate speed to increase the temperature of the mixture and set it to the reaction temperature between 100 and 350°C, wherein this step is carried out under an inert atmosphere, and the mixture of the compounds of step a) is kept at this reaction temperature for a period of time between 1 seconds and 60 minutes; and, c) collecting under an inert atmosphere the resulting $Cu_2A_xSnSe_y$ nanoparticle colloidal solution of step b).

Any preferred or particular embodiment of the process of the invention is also a preferred or particular embodiment of the colloidal solution of $Cu_2A_xSnSe_y$ nanoparticles obtainable by the process of the present invention.

The advantage of the preparation process of the present invention is that the nanoparticle colloidal solution prepared accordingly is susceptible of a roll-to-roll manufacturing, leading to substantial cost reduction. Additionally, the production of solar cells using this technology has the advantage of being highly cost efficient compared to traditional silicon-based solar cells.

The very narrow size distribution of the nanoparticles of the present invention makes them perfect for the field of solar cells.

The suitability of the nanoparticles of the present invention in the preparation of solar cells is supported by figure 8, which shows the optical absorbance spectra of nanoparticles of the present invention. In general, the prepared nanoparticles absorb light photons with energy above 0.9-1.4 eV, thus, are semiconductors with a 0.9-1.4 band gap. As disclosed in said figure, the nanoparticles of the quaternary compound $Cu_2CdSnSe_4$ have a band gap around 0.9 eV.

Moreover, the nanoparticles of the present invention have a high optical absorption coefficient. The abruptness of the absorption edge demonstrates that they are direct band gap semiconductors, which makes them ideal for photovoltaic applications.

The present invention also relates to a colloidal solution of $Cu_2A_xSnSe_y$ nanoparticles with an average size between 1 and 100 nm, and a variance of the size distribution up to 20%, wherein A is selected from Cd, Hg and Ni, $0 \leq x \leq 1$, and $3 \leq y \leq 4$. In a preferred embodiment, the above colloidal solution is selected from the group consisting of $Cu_2Hg_{0.2}SnSe_4$, $Cu_2CdSnSe_4$, $Cu_2NiSnSe_4$, $Cu_2ZnSnSe_4$, $Cu_2SnSe_3$, $Cu_2Zn_{0.1}SnSe_{3.1}$, $Cu_2Cd_{0.5}SnSe_{3.5}$ and $Cu_2HgSnSe$.

In a preferred embodiment, the nanoparticles of the colloidal solution of the present invention have an average size in the range of 10-15.

Therefore, a further aspect of the present invention is an ink comprising the colloidal solution of nanoparticles disclosed in the present invention. Any method known in the art can be used for the preparation of the ink and the photovoltaic cell using the disclosed nanoparticle colloidal solution.

The present invention, hence, also encompasses an ink comprising a binder and the colloidal solution of nanoparticles of the present invention.

The nanoparticles colloidal solution of the present invention has the following other fields of application:

a) Illumination applications, such as light-emitting diodes (LEDs), which can be constructed based on the colloidal solution of nanoparticles of the present invention. The direct band gap and the narrow variance of the size distribution of the nanoparticles are necessary conditions to build efficient LEDs. In particular, the narrow variance ensures a narrow-band luminescence, i.e. photoluminescence full-width at half-maximum (FWHM) of less than 50nm.

b) Biomedical applications, such as biological labels; given the narrow variance of the size distribution of the nanoparticles of the present invention, their photoluminescence can be easily tuned, which is an advantage for biomedical applications.

c) Thermoelectric applications, such as heat pumps and power generation. The efficiency of a thermoelectric material used for power generation or cooling applications is usually characterised by the dimensionless electric figure of merit ZT.

Consequently, in a further embodiment of the present invention, there is provided a LED comprising the nanoparticle colloidal solution of the present invention. And in still a further embodiment, it is provided a biological label comprising the nanoparticle colloidal solution of the present invention.

Throughout the description and claims the word "comprise" and variations of the word, are not intended to exclude other technical features, additives, components, or steps. Additional objects, advantages and features of the invention will become apparent to those skilled in the art upon examination of the description or may be learned by practice of the invention. The following examples and drawings are provided by way of illustration, and they are not intended to be limiting of the present invention. Furthermore, the present invention covers all possible combinations of particular and preferred embodiments described herein.

EXAMPLES

Measurements

*Average nanoparticle size and variance of the size distribution*

The average size and variance of the size distribution of the nanoparticles were calculated by measuring at least 500 nanoparticles using the TEM technique. Said parameters were obtained by applying the following formula:

$$\sigma = \sqrt{\frac{1}{N}\sum_{i=1}^{N}(x_i - \mu)^2}$$

where

$$\mu = \frac{1}{N}\sum_{i=1}^{N}x_i.$$

wherein $x_i$ is one measurement of the particle size and N is the total number of measurements.

For TEM characterization, samples were prepared by placing a drop of the colloidal solution containing the nanoparticles onto a carbon coated copper grid at room temperature and ambient atmosphere. TEM micrographs were obtained using Jeol 1010 microscope, operating at 100kV. Images were digitally acquired using a Megaview III scanning CCD camera with a soft imaging system. The TEM had been previously calibrated to ensure correct determination of the nanoparticles average size and its distribution.

*Chemical composition*

In order to determine the chemical composition of the nanoparticles, two techniques were used, i.e. XPS and EDX.

For XPS characterization, samples were prepared by placing a drop of the nanoparticle colloidal solution onto a carbon tape at room temperature and ambient atmosphere. A SPECS SAGE ESCA System employing Mg K$\alpha$ (E=1253.6 eV) with a supplied power of 203W as the X-ray source was used. Spectra were obtained using a collection time of 60 minutes per each region of the spectra.

EDS analysis was performed using a JEOL JEM 2100 transmission electron microscope. Samples were prepared as previously explained and with an Oxford INCA X-sight, with Si(Li) detector of an active area of 30 mm$^2$ and an ATW2 window, operating at 200 kV in TEM mode. Spectra acquisition was accomplished using the INCA Microanalysis Suite version 4.09 software, Collection time was set to 30 minutes.

The equipments used to measure the chemical composition were calibrated.

*Band-gap*

UV-vis measurements were obtained using a Perkin Elmer Lambda 950 spectrometer with the colloidal solutions inside a quartz cuvette and an acquisition time of 20 minutes for the full spectra from 300 to 3000 nm.

Example 1. Preparation of a colloidal solution of $Cu_2Hg_{0.2}SnSe_4$ nanoparticles having an average size of 9 nm, an 8% variance of the size distribution and spherical geometry

Fifty millimoles of CuCl (4,95 g), 100 millimoles (7,896 g), 25 millimoles of $SnCl_{4.5}H_2O$ (8,765 g), 20 millimoles of $HgCl_2$ (5,43 g) and 1 mol hexadecylamine (24,15 g) were dissolved in 100 ml of octadecene. A peristaltic pump was used to uptake the solution and flow it through a stainless steel pipe having an internal average diameter of 3 mm. The flow rate was set at 4 ml/min. The solution was flown through a pipe inside a furnace having a temperature of 100°C. Then, the reaction solution was flown through a pipe inside a second furnace set at 300°C. The length of this section was such that the solution was kept at 300°C during 10s. Then, the solution was flown through a 50 cm section cooled by a water flow, in order to cool down the resulting nanoparticle colloidal solution from 300°C to approximately 30°C, and collected in a sealed flask through a septum. The binder ethylcellulose was added to the sealed flask to a final amount of 5% in weight. The resulting solution was readily printable.

Example 2: Preparation of a colloidal solution of $Cu_2Hg_{0.2}SnSe_4$, $Cu_2CdSnSe_4$, $Cu_2NiSnSe_4$, $Cu_2ZnSnSe_4$, $Cu_2SnSe_3$, $Cu_2Zn_{0.1}SnSe_{3.1}$, $Cu_2Cd_{0.5}SnSe_{3.5}$ or $Cu_2HgSnSe_4$ nanoparticles

<u>Table 1.</u> Specific compounds as well as parameters used in the preparation process of the present invention to obtain colloidal solutions of nanoparticles of the desired composition (or stoichiometry), average size, size distribution and shape.

As shown in Table 1 below more than one set of parameters are possible.

| Sample | Np Composition | Se | A salt | A cc | Se prec |
|--------|----------------|------|--------|--------|---------|
| 1 | $Cu_2Hg_{0.2}SnSe_4$ | Se-oct | $HgCl_2$ | 0.2 M | Se-oct |
| 2 | $Cu_2Hg_{0.2}SnSe_4$ | Se-oct | $HgCl_2$ | 0.2 M | Se-oct |
| 3 | $Cu_2Hg_{0.2}SnSe_4$ | Se-oct | $HgCl_2$ | 0.2 M | Se-oct |
| 4 | $Cu_2CdSnSe_4$ | PhSeSePh | $CdCl_2$ | 0.25 M | Se-oct |
| 5 | $Cu_2CdSnSe_4$ | Se-oct | $CdCl_2$ | 0.25 M | TOPSe |
| 6 | $Cu_2CdSnSe_4$ | Se-oct | $CdCl_2$ | 0.25 M | TOPSe |
| 7 | $Cu_2CdSnSe_4$ | TOPSe | $CdCl_2$ | 0.25 M | TOPSe |
| 8 | $Cu_2NiSnSe_4$ | TOPSe | $N_2NiO_6.6H_2O$ | 0.25 M | TOPSe |
| 9 | $Cu_2ZnSnSe_4$ | TOPSe | ZnCl | 0.25 M | Se-oct |
| 10 | $Cu_2SnSe_3$ | TOPSe | None | 0.25 M | TOPSe |
| 11 | $Cu_2Zn_{0.1}SnSe_{3.1}$ | TOPSe | ZnCl | 0.25 M | TOPSe |
| 12 | $Cu_2Cd_{0.5}SnSe_{3.5}$ | Se-oct | $CdCl_2$ | 0.25 M | TOPSe |
| 13 | $Cu_2ZnSnSe_4$ | Se-oct | ZnCl | 0.25 M | Se-oct |
| 14 | $Cu_2HgSnSe_4$ | Se-oct | $HgCl_2$ | 0.4 M | Se-oct |
| 15 | $Cu_2HgSnSe_4$ | Se-oct | $HgCl_2$ | 0.4 M | Se-oct |
| 16 | $Cu_2CdSnSe_4$ | Se-oct | $CdCl_2$ | 0.25 M | Se-oct |

The solvent used in the preparation process of most of the samples of Table 1 was octadecene; for sample 3, the solvent used was squalane. The Cu precursor used for all the samples was CuCl, at a concentration of 0.5 M in the reaction mixture. The Se precursor was used at a concentration of 1 M in the reaction mixture. The Sn precursor used for all the samples was $SnCl_4 \cdot 5H_2O$, at a concentration of 0.25M in the reaction mixture. The ligand used for all samples 1-12 was hexadecylamine, at a concentration of 1 M in the reaction mixture; for samples 13-16, the ligand used was oleylamine, at a concentration of 10, 8, 20 and 10 M, respectively, in the reaction mixture. The number of feeding units used for all the samples was 1, except for sample 4, for which 2 feeding units were needed ("Np" stands for nanoparticle; "cc" stands for concentration, and refers to the concentration of the (optionally activated) precursors in the reaction mixture; "prec" stands for precursor; "Se-oct" stands for Se-octadecene; "TOPSe" stands for Se-tryoctylphosphine; and "PhSeSePh" corresponds to diphenyl diselenide).

Table 1 (continuation)

| Sample | T1 | HR | T2 | RT |
|--------|-----|-----|-----|-----|
| 1 | 100 | 50 | 300 | 10s |
| 2 | 100 | 58 | 330 | 10s |
| 3 | 100 | 58 | 330 | 1m |
| 4 | 100 | 58 | 330 | 10s |
| 5 | 100 | 58 | 330 | 5m |
| 6 | 100 | 50 | 300 | 10s |
| 7 | 100 | 49 | 295 | 5m |
| 8 | 100 | 40 | 260 | 5m |
| 9 | 100 | 49 | 295 | 5m |
| 10 | 100 | 49 | 295 | 5m |
| 11 | 100 | 49 | 295 | 5m |
| 12 | 100 | 50 | 300 | 10s |
| 13 | 100 | 53 | 310 | 5m |
| 14 | 100 | 50 | 300 | 1m |
| 15 | 100 | 51 | 305 | 1m |
| 16 | 100 | 48 | 290 | 1m |

T1 and T2 correspond to the preheating and reaction temperature, respectively. "HR" stands for heat ramp; "RT" stands for reaction time, in minutes (m) or seconds (s).

The preparation process of the present invention yielded a colloidal solution of nanoparticles with an average size in the range of 1-100 nm, preferably 5-70 nm, and more preferably, 10-30 nm, and even more preferably 10-15 nm. Such average size could be determined by any suitable technique available in the art, e.g. TEM.

The preparation process of the present invention yield a colloidal solution of nanoparticles with a size distribution up to 20%, preferably up to 15%, more preferably up to 12%, more preferably up to 10%, even more preferably 1-9%, more preferably 2-8%, and most preferably 4-6% (see Table 2 below).

Table 2. Average size (AS) and variance of the size distribution (%) (V) of nanoparticles of different compositions prepared using the preparation process of the inventors

| Sample | AS | V (%) |
|--------|-----|-------|
| 1 | 9 | 8 |

(continued)

| Sample | AS | V (%) |
|---|---|---|
| 2 | 15 | 7 |
| 3 | 18 | 10 |
| 4 | 65 | 15 |
| 5 | 30 | 18 |
| 6 | 45 | 15 |
| 7 | 15 | 15 |
| 8 | 11 | 12 |
| 9 | 18 | 10 |
| 10 | 15 | 10 |
| 11 | 15 | 10 |
| 12 | 50 | 15 |
| 13 | 40 | 20 |
| 14 | 25 | 10 |
| 15 | 16 | 10 |
| 16 | 20 | 20 |

**Claims**

1. A continuous flow process for the preparation of a colloidal solution of $Cu_2A_xSnSe_y$ nanoparticles, with an average size between 1 and 100 nm, and a variance of the size distribution up to 20%, wherein A is selected from Cd, Hg, Ni and Zn, $0 \leq x \leq 1$, and $3 \leq y \leq 4$, the process comprising:

   a) mixing in a continuous flow reaction unit under inert atmosphere and at an appropriate temperature, an appropriate amount of each of the following compounds to obtain an appropriate concentration of each of them in the mixture in order to yield nanoparticles of the desired average size, size distribution, shape and stoichiometry:

   i) a solution of an A salt in an inert organic solvent
   ii) a solution of a Sn salt in an inert organic solvent;
   iii) a solution of a Cu salt in an inert organic solvent;
   iv) a Se coordination compound; and,
   v) one or more stabilising agents selected from the group consisting of a primary $(C_{12}-C_{18})$-amine, a $(C_{12}-C_{18})$-carboxylic acid, a $(C_{10}-C_{14})$-phosphonic acid, and a mixture of any of the $(C_{12}-C_{18})$-amines with any of the acids;
   wherein the inert organic solvent is the same or a different one for each salt, and wherein the inert organic solvent has a dielectric constant <10, and a boiling temperature comprised between 100 and 350°C;

   b) progressively heating the mixture of the compounds of step a) at an appropriate speed to increase the temperature of the mixture and set it to the reaction temperature between 100 and 350°C, wherein this step is carried out under an inert atmosphere, and the mixture of the compounds of step a) is kept at this reaction temperature for a period of time between 1 seconds and 60 minutes; and,
   c) collecting under an inert atmosphere the resulting $Cu_2A_xSnSe_y$ nanoparticle colloidal solution of step b).

2. The process according to claim 1, wherein one or more of compounds i) to iv) of step a) are preheated at a temperature comprised between 50 and 100 °C to activate them before the progressive heating of step b).

3. The process according to any of the claims 1-2, wherein the resulting $Cu_2A_xSnSe_y$ nanoparticle colloidal solution is cooled.

4. The process according to any of the claims 1-3, wherein a binder is added to the colloidal solution between steps b) and c) or after step c).

5. A colloidal solution of $Cu_2A_xSnSe_y$ nanoparticles with an average size between 1 and 100 nm, and a variance of the size distribution up to 20%, wherein A is selected from Cd, Hg and Ni, $0 \leq x \leq 1$, and $3 \leq y \leq 4$.

6. The colloidal solution of claim 5, wherein the nanoparticles have an average size in the range of 10-15.

7. The colloidal solution of any of the claims 5-6, wherein the $Cu_2A_xSnSe_y$ nanoparticles are selected from the group consisting of $Cu_2H_{0.2}SnSe_4$, $Cu_2CdSnSe_4$, $Cu_2NiSnSe_4$, $Cu_2SnSe_3$, $Cu_2Zn_{0.1}SnSe_{3.1}$, $Cu_2Cd_{0.5}SnSe_{3.5}$ and $Cu_2HgSnSe_4$.

8. Use of the colloidal solution as defined in any of the claims 5-7 for the conversion of photons into an electric signal.

9. Use of the colloidal solution as defined in any of the claims 5-7 for the conversion of photons into electric energy.

10. A photovoltaic cell comprising the colloidal solution of any of the claims 5-7.

11. Use of the colloidal solution as defined in any of the claims 5-7, for the conversion of thermal energy into electric energy.

12. A thermoelectric device comprising the colloidal solution of any of the claims 5-7.

13. A method for the manufacture of a photovoltaic cell, comprising preparing a colloidal solution as defined in any of the claims 1-4, and applying the colloidal solution onto an appropriate substrate.

14. A method for the manufacture of a photodetector, comprising preparing a colloidal solution as defined in any of the claims 1-4, and applying the solution onto an appropriate substrate.

15. A method for the manufacture of a thermoelectric device, comprising preparing a colloidal solution as defined in any of the claims 1-4, and applying the solution onto an appropriate substrate.

FIG.1

FIG. 2

FIG. 3

FIG. 4

FIG. 5

EP 2 497 588 A1

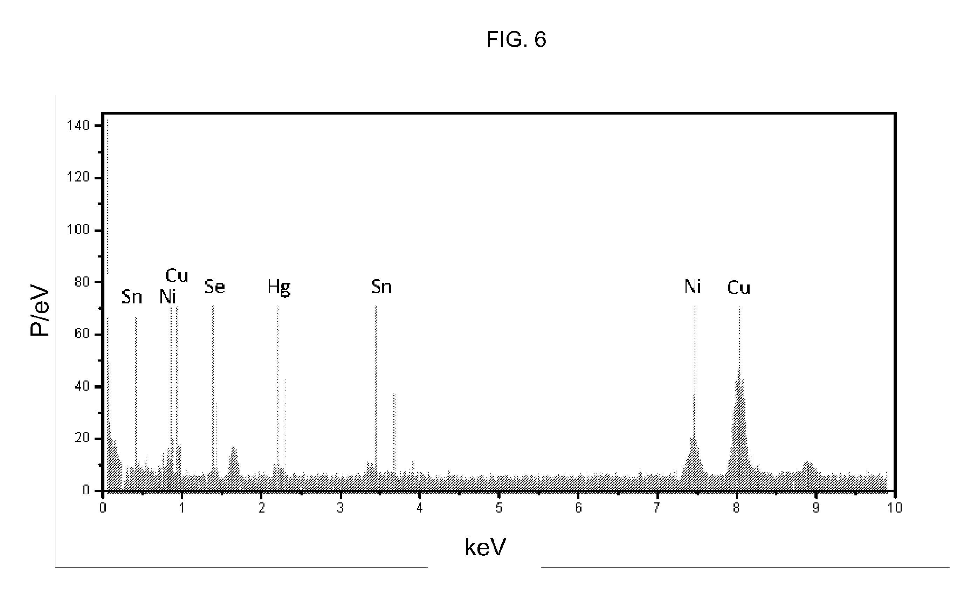

FIG. 6

FIG. 7

$Cu_2Hg_{0.2}SnSe_4$

FIG. 8

FIG. 9

| | Europäisches Patentamt |
|---|---|
| | European Patent Office |
| | Office européen des brevets |

**EUROPEAN SEARCH REPORT**

Application Number

EP 11 38 2064

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | ALEXEY SHAVEL, JORDI ARBIOL AND ANDREU CABOT: "Synthesis of Quaternary Chalcogenide Nanocrystals: Stannite Cu2ZnxSnySe1+x+2y", JACS, vol. 132, 16 March 2010 (2010-03-16), pages 4514-4515, XP002660184, * the whole document * | 1-4 | INV. B22F9/24 B22F1/00 H01L31/0352 |
| A | WO 2009/137637 A2 (UNIV TEXAS [US]; KORGEL BRIAN A [US]; PANTHANI MATTHEW G [US]; GOODFEL) 12 November 2009 (2009-11-12) * abstract; claims 45-68 * | 1-4 | |
| A | WO 2009/127857 A1 (TRACKDALE LTD [GB]; O'CONNOR STEPHEN JOHN MARTIN [GB]; DOHERTY RACHEL) 22 October 2009 (2009-10-22) * abstract; claims 1-20 * | 1-4 | |
| A | Redinger: APPLIED PHYSICS LETTERS, 1 January 2010 (2010-01-01), page 092111, XP055001267, Retrieved from the Internet: URL:http://scitation.aip.org/getpdf/servlet/GetPDFServlet?filetype=pdf&id=APPLAB0000970000009092111000001&idtype=cvips&doi=10.1063/1.3483760&prog=normal [retrieved on 2011-06-23] * the whole document * | 1-4 | TECHNICAL FIELDS SEARCHED (IPC)  B22F H01L |

-/--

~~The present search report has been drawn up for all claims~~

| Place of search | Date of completion of the search | Examiner |
|---|---|---|
| Munich | 29 September 2011 | Liu, Yonghe |

Europäisches
Patentamt

European
Patent Office

Office européen
des brevets

# EUROPEAN SEARCH REPORT

Application Number

EP 11 38 2064

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | SHI, HUANG, LIU, AND CHENB: "Thermoelectric properties of tetrahedrally bonded wide-gap stannite compounds Cu2ZnSn1xInxSe4", APPLIED PHYSICS LETTERS, vol. 94, 122103, 23 March 2009 (2009-03-23), pages 1-3, XP002660185, * the whole document * | 1-4 | |

-----

TECHNICAL FIELDS
SEARCHED (IPC)

The present search report has been drawn up for all claims

| Place of search | Date of completion of the search | Examiner |
|---|---|---|
| Munich | 29 September 2011 | Liu, Yonghe |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

Europäisches
Patentamt

European
Patent Office

Office européen
des brevets

**Application Number**

EP 11 38 2064

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1-4

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

Application Number

EP 11 38 2064

The Search Division considers that the present European patent application does not comply with the
requirements of unity of invention and relates to several inventions or groups of inventions, namely:

    1. claims: 1-4

            a process for the preparation of a colloidal solution
                        ---

    2. claims: 5-7, 10, 12

            a colloidal solution and products based on it
                        ---

**ANNEX TO THE EUROPEAN SEARCH REPORT
ON EUROPEAN PATENT APPLICATION NO.**

EP 11 38 2064

This annex lists the patent family members relating to the patent documents cited in the above-mentioned European search report.
The members are as contained in the European Patent Office EDP file on
The European Patent Office is in no way liable for these particulars which are merely given for the purpose of information.

29-09-2011

| Patent document cited in search report | | Publication date | Patent family member(s) | | Publication date |
|---|---|---|---|---|---|
| WO 2009137637 | A2 | 12-11-2009 | TW<br>US<br>WO | 201008868 A<br>2011056564 A1<br>2009137637 A2 | 01-03-2010<br>10-03-2011<br>12-11-2009 |
| WO 2009127857 | A1 | 22-10-2009 | NONE | | |

For more details about this annex : see Official Journal of the European Patent Office, No. 12/82